# EUROPÄISCHE PATENTSCHRIFT

(11) **EP 1 929 847 B1**
(45) Veröffentlichungstag und Bekanntmachung des Hinweises auf die Patenterteilung: **18.03.2009**
(21) Anmeldenummer: 06764067.2
(22) Anmeldetag: 05.07.2006
(51) Int. Cl.: H05K 1/02

(54) **LEITERPLATTE**
PRINTED BOARD
CARTE DE CIRCUITS IMPRIMES

(30) Priorität: 30.09.2005 DE 102005047025
(43) Veröffentlichungstag der Anmeldung: 11.06.2008
(73) Patentinhaber: Siemens Home and Office Communication Devices GmbH & Co. KG, 81379 München (DE)
(72) Erfinder: BUSCH, Georg, 48683 Ahaus (DE); DETERING, Volker, 46446 Emmerich (DE); HINKEN, Ludger, 87435 Kempten (DE); LORENZ, Ralf, 46325 Borken- Gemen (DE)
(74) Vertreter: Maier, Daniel Oliver
(86) Internationale Anmeldenummer: PCT/EP2006/063909
(87) Internationale Veröffentlichungsnummer: WO 2007/039331

(56) Entgegenhaltungen:
- WO-A2-03/096414
- DE-A1- 10 064 221
- FR-A1- 2 777 734

## Beschreibung

Die Erfindung betrifft eine Leiterplatte gemäß dem Oberbegriff des Anspruchs 1.

Liegt bei Anwendungen im Innen- und Außenbereich das Problem der Entwärmung von Hochleistungsendstufentransistoren, beispielsweise Hochfrequenz-Hochleistungsendstufentransistoren, bei Umgebungstemperaturen größer 40°C vor werden üblicherweise Hochleistungsendstufentransistoren verwendet, die von Hand direkt auf einem Kühlkörper montiert werden. Damit wird eine sehr gute Entwärmung des Bauteils und damit der mit diesem Bauteil realisierten Endstufe erreicht. Die elektrischen Verbindungen zwischen einer zugehörigen Nutzschaltung, beispielsweise eine Hochfrequenzschaltung, die von der genannten Endstufe mit Energie versorgt wird, und den Hochleistungsendstufentransistoren sind mit Hilfe spezieller Anschlussleitungen hergestellt. Die Längen der Leitungen und die genauen Positionen an den zugehörigen Anschlusspins sind dabei entscheidend für die Funktion der Nutzschaltung, insbesondere dann, wenn es sich dabei um eine Hochfrequenzschaltung handelt.

Ohne besondere Wärmeableitungsmaßnahmen bei der Anschlusstechnik der Hochleistungsendstufentransistoren bzw. allgemein eines betreffenden Hochleistungsbauteils würden bei einer heute angestrebten Leistung der Endstufe die Hochleistungsbauteile bereits bei einer Umgebungstemperatur von 20°C in kurzer Zeit zerstört werden. Alternativ müsste die Leistung der Endstufe stark reduziert werden.

Aus fertigungstechnischen Gründen ist es günstig, die Nutzschaltung einschließlich der zugehörigen Endstufe in SMD-Technologie zu realisieren. Bei Verwendung der bisher bekannten SMD-Technologien kann die erzeugte Abwärme bei Raumtemperatur jedoch nicht beziehungsweise nicht genügend abgeführt werden. Der Wärmewiderstand bekannter Lösungen ist deutlich zu hoch. Außerdem begrenzen die Abstände zwischen den Anschlussbeinchen der SMD-Leistungsbauteile, die sich in Arbeit insbesondere in einem Erhitzungsbereich zwischen den Anschlussbeinchen erhitzen, die maximale Größe eines heute schon verwendeten so genannten Inlays erheblich, das gut bis sehr gut wärmeleitend ist und innerhalb der Ebene der der Nutzschaltung bzw. der Endstufe zu Grunde liegenden Leiterplatte angeordnet ist. Ein solches Inlay ist innerhalb der Leiterplatte unterhalb eines Leistungsbauteils mit der Dicke der Leiterplatte positioniert und leitet die vom Leistungsbauteil erzeugte Wärme von der einen Seite der Leiterplatte, auf der das SMD-Leistungsbauteil angeordnet ist, durch die Leiterplatte hindurch auf die andere Seite, auf der ein Kühlkörper zur Abstrahlung der vom SMD-Leistungsbauteil erzeugten und mit Hilfe des Inlays durch die Leiterplatte hindurchgeleiteten Wärme angeordnet ist.

Die Abstände zwischen den Anschlussbeinchen der Leistungsbauteile sind zu klein, um für die geforderte Leistung ein genügend großes Inlay darunter anordnen zu können, das in der Lage ist, die bei der geforderten Leistung in einem darüber angeordneten Leistungsbauteil entstehende Wärme genügend schnell durch die Leiterplatte hindurch auf den Kühlkörper auf der anderen Seite der Leiterplatte ab zu leiten. Ein über die Abstände der Anschlussbeinchen eines Leistungsbauteils hinausgehendes Inlay würde dazu führen, dass die Anschlussbeinchen direkt auf dem Inlay zu liegen kämen, weshalb es dann erstens keine Anschlussmöglichkeiten für den elektrischen Anschluss der Anschlussbeinchen an eine zugehörige Schaltung mehr gäbe und zweitens Kurzschlüsse über das Inlay aufträten.

Eine Anordnung gemäß dem Stand der Technik, wie sie oben näher erläutert ist, ist beispielsweise aus dem Dokument DE 100 64 221 A1 bekannt. Aus diesem Dokument ist insbesondere eine Leiterplatine mit gekühltem SMD-Baustein sowie Verfahren zu deren Herstellung bekannt, die ein Inlay aufweist, um die erzeugte Wärme eines darüber angeordneten Bauteils durch die Leiterplatte hindurch auf einen auf der anderen Seite der Leiterplatte angeordneten Kühlkörper zu leiten. Dabei passt das Inlay von seiner Größe her genau zwischen die Anschlussbeinchen des zu kühlenden Bauteils.

Aus dem Dokument WO 03/096414 A2 ist eine Leiterplatte mit wärmeleitendem, sich innerhalb der Ebene der Leiterplatte mit der Dicke der Leiterplatte erstreckendem, wärmeleitendem Inlay zum durch die Leiterplatte Hindurchleiten von Wärme wenigstens eines einzigen auf der einen Seite der Leiterplatte über dem Inlay angeordneten, sich in Arbeit erhitzendem elektrischen SMD-Bauteils mit zugehörigen Anschlussbeinchen und einem dazwischen angeordneten Erhitzungsbereich hin zu einem auf der anderen Seite der Leiterplatte angeordneten Kühlkörper bekannt, wobei die Erstreckung des Inlays größer ist als der von zugehörigen Anschlussbeinchen eingeschlossene Erhitzungsbereich des wenigstens einzigen über dem Inlay angeordneten SMD-Bauteils.

Daneben ist aus dem Dokument FR 2 777 734 A1 eine Flachbaugruppe bekannt mit einer Leierplatte, die eine Aussparung aufweist, in die ein nasenartiges Stück einer unterhalb der Leiterplatte angeordneten Kühlplatte ragt, wobei auf der Leiterplatte über der besagten, darunter angeordneten Aussparung ein zu kühlender Transistor angeordnet ist.

Ausgehend von einer Leiterplatte der eingangs genannten Art ist es Aufgabe der vorliegenden Erfindung, eine solche Leiterplatte in der Weise zu verbessern, dass sie geeignet ist, insbesondere für SMD-Hochleistungsendstufentransistoren der höchsten Leistungsklasse, beispielsweise mit Wärmeleistungen von bis zu 10 bis 15 Watt, verwendet zu werden.

Diese Aufgabe wird erfindungsgemäß durch eine Leiterplatte gelöst, die die Merkmale im kennzeichnenden Teil des Anspruchs 1 aufweist.

Eine danach ausgebildete Leiterplatte hat gegenüber bisherigen Leiterplatten ein wesentlich größeres Inlay unterhalb der zu kühlenden Leistungsbauteile. Dieses größere Inlay ist in der Lage, die Wärme in einer wesentlich größeren Rate abzuleiten. Als Beispiel sei genannt, dass das Inlay dreimal so groß sein kann als das zu kühlende Bauteil. Das Inlay ist so groß, dass es mindestens bis unterhalb, vorzugsweise aber weiter als unterhalb der Anschlussbeinchen des zu kühlenden Bauteils reicht. Damit wiederum kann auch ein entsprechend größerer Kühlkörper mit entsprechend verbesserter Kühlleistung auf der anderen Seite der Leiterplatte vorgesehen sein. Es treten trotzdem keine Kurzschlüsse über das Inlay auf und Anschlussleitungen für die Leitungsanschlüsse zu den Anschlussbeinchen der Leistungsbauteile können bereitgestellt werden.

Auf Grund der Größe des Inlays ist der Kühlkörper sogar direkt am Inlay befestigbar. Es gibt genügend Platz für die Anbringung von Befestigungsmitteln hierfür, zum Beispiel für Schrauben. Damit besteht nicht nur eine entsprechend vergrößerte Kontaktfläche zwischen dem Inlay und dem Kühlkörper, sondern auch ein entsprechend intensivierter Kontakt zwischen diesen Teilen, weil die Befestigungsmittel den Kühlkörper fest an das Inlay pressen. Der Wärmeübergangswiderstand ist somit stark verkleinert. Außerdem trägt ein vergrößerter Kühlkörper zu einem wesentlich größeren Kühleffekt bei. Insgesamt wird mit den erfindungsgemäßen Maßnahmen ein leistungsstarker Kühlprozess unterstützt.

Zwar existiert im Grundsatz nach wie vor zwischen dem zu kühlenden Bauteil und dem Inlay ein Temperaturübergangsbereich, der von seiner flächigen Ausdehnung parallel zur Leiterplatte her von den Abständen der Anschlussbeinchen des zu kühlenden Bauteils bestimmt ist. In Richtung Inlay aber weist dieser Übergangsbereich nur eine sehr geringe Dicke auf, nämlich die Dicke einer oberhalb der Leiterplatte angeordneten Zusatzlage mit als Grundlage einer zugehörigen Trägerschicht bestehend aus einem entsprechenden Leiterplattenmaterial. Dann erfolgt der Übergang auf den wesentlich vergrößerten Querschnitt des jetzt wesentlich größeren Inlays. Dieser vergrößerte Querschnitt reicht bis zum Kühlkörper.

Die abzuführende Wärme muss also nicht mehr die ganze Dicke der Leiterplatte in dem bisher bekannten reduzierten Querschnitt durchdringen, bis sie auf den Kühlkörper trifft. Sie hat diesen reduzierten Querschnitt lediglich noch in der geringen Dicke der oberhalb der Leiterplatte angeordneten Zusatzlage samt dünner Trägerschicht zu durchdringen. Damit erhöht sich zwar die von der abzuführenden Wärme zu durchdringende Gesamtdicke zwischen dem wärmeerzeugenden Bauteil und dem Kühlkörper, trotzdem verbessert sich der Gesamtleitwert auf der gesamten Durchdringungsstrecke, weil der größte Anteil der Durchdringungsstrecke mit einem wesentlich verbesserten Wärmeleitwert behaftet ist.

Die Zusatzlage dient dabei einerseits dazu, das zu kühlende Bauteil gegenüber dem Inlay zu isolieren, und andererseits dazu, die Anschlussleitungen für den Anschluss der Anschlussbeinchen des zu kühlenden Bauteils zur Verfügung zu stellen.

Die vom zu kühlenden Leistungsbauteil erzeugte Wärme kann insgesamt wesentlich schneller und in einer wesentlich größeren Menge an den zusätzlich noch vergrößerten Kühlkörper geleitet werden. Es kommt nicht mehr so einfach zu einem Hitzestau innerhalb der Leiterplatte, weshalb wesentlich leistungsstärkere Bauteile, insbesondere auch SMD-Bauteile, verwendbar geworden sind.

Dabei ist es besonders vorteilhaft, wenn die Zusatzlage eine Micro-Lage ist. In diesem Fall ist die Dicke der Zusatzlage besonders gering, weswegen der Wärmeaustausch vom Leistungsbauteil zum Inlay noch wirkungsvoller möglich ist.

Damit dieser Wärmeaustausch besonders wirkungsvoll ist, sind unterhalb des Erhitzungsbereichs eines über dem Inlay angeordneten zu kühlenden SMD-Bauteils unter Erfassung möglichst des gesamten Erhitzungsbereichs des betreffenden SMD-Bauteils innerhalb der Zusatzlage wärmetechnische Vorkehrungen getroffen, durch die die Wärme von dem Erhitzungsbereich des zu kühlenden SMD-Bauteils gut bis sehr gut zum darunter angeordneten Inlay befördert ist. Dies kann eine Verlötung am Erhitzungsbereich des zu kühlenden Bauteils einschließen.

Andere Vorteile der erfindungsgemäßen Maßnahmen sind, dass durch die Verwendung von SMD-Bauteilen für die Hochleistungsendstufentransistoren auf eine Handmontage verzichtet werden kann. Die elektrischen Verbindungen zwischen den Hochleistungsendstufentransistoren und einer übrigen Schaltung ist bereits auf der Leiterplatte realisierbar. Weiter sind SMD-Bauteile deutlich günstiger als entsprechende geschraubte Versionen. Ein spezieller Hochfrequenz-Abgleich der Anschlussleitungen, wie das in gegebenen Fällen bei händischer Montage nötig ist, entfällt. Das Bauvolumen der Schaltung reduziert sich wesentlich. Die Anwendung der hier vorgeschlagenen Entwärmungstechnik kann grundsätzlich auch für andere Bauformen verwendet werden.

Vorteilhafte Ausgestaltungen der Erfindung sind Gegenstand von Unteransprüchen

Danach ist der bezüglich der SMD-Bauteile auf der anderen Seite der Leiterplatte angeordnete Kühlkörper mit technischen Mitteln, beispielsweise die bereits erwähnten Schrauben, an das Inlay gepresst, so dass sich ein sehr geringer Wärmeübergangswiderstand zwischen dem Inlay und dem Kühlkörper einstellt.

Der Umstand, dass der Kühlkörper am Inlay befestigt werden kann, ist erst durch die erfindungsgemäßen Maßnahmen gegeben, weil erst durch diese Maßnahmen das Inlay so groß geworden ist, dass Platz für Befestigungsmittel vorhanden ist. Außerdem hat die Befestigung des Kühlkörpers am Inlay den Vorteil, dass Verwindungen der Leiterplatte vermieden sind, die auftreten können, wenn die Befestigungsmittel an der Leiterplatte angreifen und ungleichmäßig fest angezogen sind.

Ist auch auf der anderen Seite der Leiterplatte zwischen dem Inlay und dem Kühlkörper eine entsprechende Zusatzlage vorgesehen, hat dies fertigungstechnische Vorteile, weil die beiden Zusatzlagen auf der einen und der anderen Seite der Leiterplatte in einer symmetrischen Weise hergestellt werden können. Durch die Herstellung der Leiterplatte in symmetrischer Weise ist die Gefahr, dass sich die Leiterplatte wegen einseitig auftretenden Spannungen in der Leiterplatte verwindet, gebannt. Außerdem kann die zweite Zusatzlage auch für Leitungsverlegungen verwendet sein, so dass sich komplexere Schaltungsstrukturen realisieren lassen. Auch ist es möglich, die zweite Zusatzlage zwischen dem Inlay und dem Kühlkörper mit einer geerdeten Abschirmschicht zu versehen, so dass Hochfrequenz-Abstrahlungen zum Beispiel dann, wenn mit Hilfe der Leiterplatte eine Hochfrequenzschaltung realisiert ist, verhindert sind.

Wie schon im Zusammenhang mit der ersten Zusatzlage angesprochen weist gegebenenfalls auch die zweite Zusatzlage wärmetechnische Vorkehrungen zwischen dem Inlay und dem Kühlkörper auf, damit die abzuführende Wärme vom Inlay durch die Zusatzlage hindurch zum Kühlkörper gut bis sehr gut von statten geht. Dies ist beispielsweise dann der Fall, wenn das Inlay nicht selbst bis zum Ende der zweiten Zusatzlage reicht. Der durch die wärmetechnischen Vorkehrungen bewerkstelligte Wärmeübergang ist dabei wiederum umso besser, je dünner die zweite Zusatzlage ist. Vorteilhafter Weise ist daher diese Zusatzlage ebenfalls eine Micro-Lage. Sind solche wärmetechnischen Vorkehrungen vorhanden, wird der Kühlkörper nicht an das Inlay gepresst, sondern an die wärmetechnischen Vorkehrungen. Dabei kann die eigentliche Befestigung des Kühlkörpers immer noch am Inlay erfolgen.

Die wärmetechnischen Vorkehrungen in den Zusatzlagen können in der Weise ausgeführt sein, dass durch sie innerhalb von Durchgangsöffnungen in den betreffenden Zusatzlagen eine Verfüllung dieser Durchgangsöffnungen mit einem gut bis sehr gut wärmeleitendem Material bewerkstelligt ist. Die Durchgangsöffnungen stellen damit so etwas wie eine mit zum Beispiel Lötzinn gefüllte Lotwanne dar. Der Vorteil ist, dass solche Verfüllungen automatisiert herzustellen sind.

Die wärmetechnischen Vorkehrungen können in einem anderen Ausführungsfall in der Weise realisiert sein, dass durch sie eine möglichst große Anzahl von mit einem wärmetechnisch gut bis sehr gut leitendem Material verfüllte Vias, gegebenenfalls Micro-Vias, wenn die Zusatzlage eine Micro-Lage ist, bereitgestellt sind. Diese Vias lassen sich mit der Herstellung der Zusatzlage nach herkömmlichen Leiterplatten technischen Methoden erzeugen. Bei einer genügend großen Anzahl von solchen Vias entspricht der Wärmeübergang praktisch dem, der durch ein massives Inlay zur Verfügung gestellt ist, ohne dass ein massives Inlay bis zum Ende einer Zusatzlage benötigt ist. Die Vias können beispielsweise mit Kupfer, mit Lötzinn, mit Wärmeleitpaste mit hohem Silberanteil oder ähnlichem gefüllt sein.

Die Leiterplatte selbst kann eine Mehrlagenleiterplatte sein, die für komplexe Schaltungsrealisierungen verwendbar ist. Dabei können unterschiedliche Lagen mit unterschiedlichen Leiterplattenmaterialien realisiert sein. Beispielsweise kann eine oberste Lage mit einem Material für Hochfrequenzschaltungen, bekannt beispielsweise unter der Bezeichnung IS620, und die weiteren Lagen mit einem Standardleiterplattenmaterial, bekannt beispielsweise unter der Bezeichnung FR5, realisiert sein. Des Weiteren kann zum Beispiel auch die Zusatzlage zwischen den Leistungsbauelementen und dem Inlay mit einem hochfrequenztechnisch geeigneten Material und die Zusatzlage zwischen dem Inlay und dem Kühlkörper mit einem Standardleiterplattenmaterial realisiert sein. Auf diese Weise ergibt sich eine sehr kostengünstige Hybridleiterplatte beispielsweise für eine hochfrequenztechnische Leistungs- und Hauptschaltung, beispielsweise eine aus SMD-Bauteilen bestehende Hochleistungs-Endstufe und eine zugehörige Hochfrequenzschaltung, die mit herkömmlichen Schaltungsteilen kombiniert ist.

Die Verbindungen zwischen den einzelnen Lagen, auch Leitungsverbindungen, können mit Hilfe entsprechender Durchkontaktierungen, gegebenenfalls auch mit Micro-Vias und anderen Vias, bewerkstelligt sein.

Nachfolgend wird die Erfindung an Hand einer Zeichnung näher erläutert. Darin zeigen:
- Figur 1: einen Ausschnitt in Seitenansicht einer erfindungsgemäßen Leiterplatte, schematisiert dargestellt, und
- Figur 2: einen Ausschnitt in Draufsicht der Leiterplatte gemäß Figur 1, ebenfalls schematisiert dargestellt.

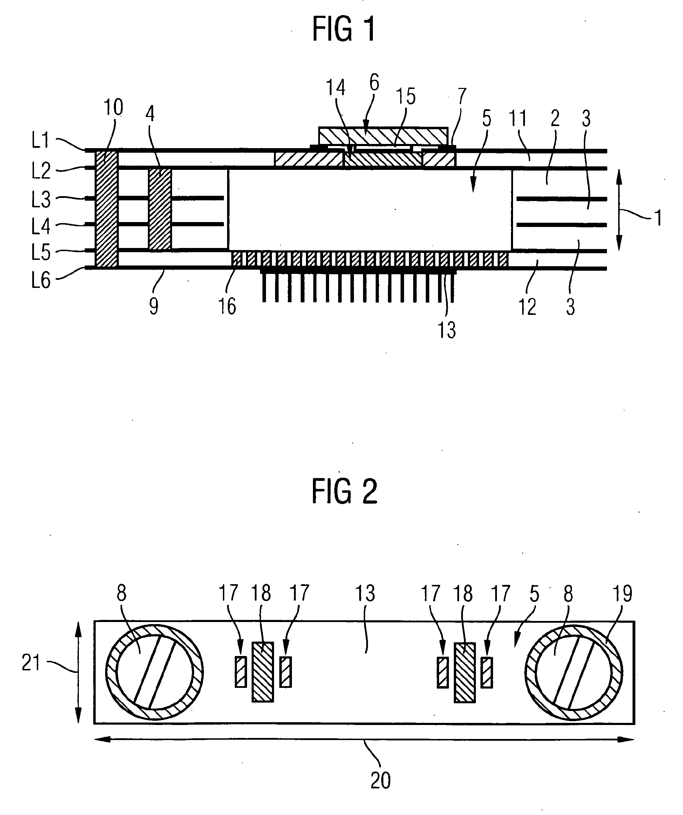

In der Figur 1 ist eine Mehrlagenleiterplatte 1 zu sehen, die beispielsweise eine Dicke von 1 mm hat.

Die Mehrlagenleiterplatte 1 umfasst vier Lagen, die mit L2, L3, L4 und L5 gekennzeichnet sind.

Gemäß dem Ausführungsbeispiel ist das Leiterplattenmaterial 2 zwischen den Lagen L2 und L3 ein Leiterplattenmaterial, das unter der Bezeichnung IS620 bekannt ist. Das Leiterplattenmaterial 3 zwischen den Lagen L3 und L4 einerseits und L4 und L5 andererseits ist ein Leiterplattenmaterial, das unter der Bezeichnung FR5 bekannt ist.

Als Beispiel für das Vorhandensein von möglichen Durchkontaktierungen ist eine einzige Durchkontaktierung 4 gezeigt, die eine Verbindung zwischen in der Zeichnung nicht näher dargestellten Leiterbahnen der Lagen L2 und L5 herstellt.

Weiter ist zwischen den Lagen L2 bis L5 ein Inlay 5 in der Ebene der Mehrlagenleiterplatte 1 integriert. Da das Inlay 5 von der Lage L2 bis zur Lage L5 reicht, weist es die Dicke der Mehrlagenleiterplatte 1 auf, nämlich 1 mm. Das Inlay 5 ist im vorliegenden Ausführungsbeispiel ein massiver Kupferblock. Dieser kann bei der Herstellung der Mehrlagenleiterplatte 1 in eine entsprechende Aussparung in der Mehrlagenleiterplatte 1 eingepresst sein.

Nach dem Einpressen des Kupferblocks ist die Mehrlagenleiterplatte 1 gemäß der Figur 1 zusätzlich noch mit zwei äußeren Lagen L1, L6 versehen worden.

Die Lage L1 ist diejenige Seite der Mehrlagenleiterplatte 1, die mit den Schaltungsbauteilen, hier in der Figur 1 beispielhaft durch ein als Hochfrequenz-Hochleistungsendstufentransistor ausgebildetes Bauteil 6 dargestellt, bestückt ist. Die Lage L6 ist im vorliegenden Ausführungsbeispiel als eine Abschirmlage 9, die eine Hochfrequenz-Abschirmung in Richtung nach außen der Mehrlagenleiterplatte 1 bewerkstelligt, ausgebildet. Hierzu ist diese Lage L6 mit einem in der Zeichnung nicht näher dargestellten Masseanschluss verbunden. Es ist aber möglich, diese Lage auch oder alleine für Leitungsstrukturen zu nutzen.

Wie die Figur 1 weiter zeigt, können die Lagen L1 und L6 mit Durchkontaktierungen 10 beispielsweise im Rahmen von Leitungsverbindungen innerhalb einer Gesamtschaltung in Verbindung gebracht sein.

Das Leiterplattenmaterial 11 zwischen den Lagen L1 und L2 ist im vorliegenden Ausführungsbeispiel das gleiche Leiterplattenmaterial, das auch als Leiterplattenmaterial zwischen den Lagen L2 und L3 verwendet ist. Die Dicke dieses Leiterplattenmaterials 11 ist im vorliegenden Ausführungsbeispiel 100 µm.

Das Leiterplattenmaterial 12 zwischen den Lagen L5 und L6 ist im vorliegenden Ausführungsbeispiel das gleiche Leiterplattenmaterial, wie es als Leiterplattenmaterial 3 beispielsweise zwischen den Lagen L4 und L5 verwendet ist. Dabei weist das Leiterplattenmaterial 12 im vorliegenden Ausführungsbeispiel eine Dicke von 50 bis 100 µm auf.

Durch die mit L1 bezeichnete Zusatzlage sind die auf der Zusatzlage L1 verschalteten Bauteile 6 zumindest in Bezug auf deren Anschlussbeinchen 7 isoliert von der darunter angeordneten Lage L2 beziehungsweise dem Inlay 5. Es ist deshalb möglich, Bauteile 6 mit ihren Anschlussbeinchen 7 direkt über dem Inlay 5 anzuordnen, auch wenn das Inlay 5 in seiner Ausdehnung in der Ebene der Mehrlagenleiterplatte 1 wesentlich größer als der Abstand zwischen den Anschlussbeinchen 7 eines darüber angeordneten Bauteils 6 ist.

Das Inlay 5 reicht in seinen Abmessungen soweit über die Anschlussbeinchen 7 des darüber angeordneten Bauteils 6, dass noch mechanische Befestigungsschrauben 8 (Figur 2) am Inlay 5 vorgesehen sein können, beispielsweise für die massive mechanische Befestigung eines Kühlkörpers 13 daran.

Der Kühlkörper 13 ist auf der Lage L6 unterhalb des Inlays 5 angeordnet. Er gibt die Wärme des oberhalb des Inlays 5 angeordneten Bauteils 6 zu dessen Kühlung an die Umgebung ab.

Hierzu wird die Wärme des Bauteils 6 über ein im vorliegenden Ausführungsbeispiel Lotdepot 14 innerhalb der Lage L1 und dem Leiterplattenmaterial 11 von einem Erhitzungsbereich 15 des Bauteils 6 zwischen den Anschlussbeinchen 7 des Bauteils 6, das Inlay 5 und einer möglichst großen Vielzahl von Vias 16 unterhalb des Inlays 5 im Leiterplattenmaterial 12 und der Lage L6 zum Kühlkörper 13 geleitet.

Die Leiterplattenmaterialien 11 und 2 sind hochfrequenztaugliche Leiterplattenmaterialien, während die Leiterplattenmaterialien 3 und 12 herkömmliche Leiterplattenmaterialien sind.

Das Bauteil 6, die Lagen L1 und L2 sowie die Leiterplattenmaterialien 11 und 2 stehen in dem hier aufgezeigten Ausführungsbeispiel stellvertretend für eine Hochfrequenz-Hochleistungsschaltung, die mit der vorliegenden Leiterplatte realisiert ist. Die übrigen Lagen und Leiterplattenmaterialien stehen stellvertretend für eine herkömmliche Schaltungsanordnung, die mit der Hochfrequenz-Hochleistungsschaltung kombiniert ist.

Der Kühlkörper 13 ist, wie schon gesagt, mit Schrauben 8 am Inlay 5 befestigt. Dies ist in der Figur 2 kenntlich gemacht. Ansonsten sind in der Figur 2 das Inlay 5, die relativen Positionen 17 für die Anschlussbeinchen 7, die relativen Positionen 18 für Lotdepots 14 und der Kühlkörper 13 in ihrer prinzipiellen Zuordnung zueinander sichtlich gemacht. Die Schrauben 8 sind dabei mit Unterlegscheiben 19 versehen.

Der in der Figur 2 gezeigte Ausschnitt hat in der Natur eine Länge 20 von circa 35 mm und eine Breite 21 von circa 5 mm.

Das in der Zeichnung angesprochene Bauteil 6 beziehungsweise die durch das Bauteil 6 allgemein verkörperten, im Zusammenhang mit der vorliegenden Leiterplatte verwendeten elektronischen Bauteile können von der Art eines SMD-Bauteils sein.

Dabei ist auch die Verwendung jeglicher Art von IC-Bauteilen möglich.

Im vorliegenden Ausführungsbeispiel ist die Zusatzlage L6 als Micro-Via-Lage realisiert, so dass die Vias 16 zum Kühlkörper 13 hin als Micro-Vias ausgebildet sind.

## Patentansprüche

1. Leiterplatte mit wärmeleitendem, sich innerhalb der Ebene der Leiterplatte mit der Dicke der Leiterplatte erstreckendem, gut bis sehr gut wärmeleitendem Inlay zum durch die Leiterplatte Hindurchleiten von Wärme wenigstens eines einzigen auf der einen Seite der Leiterplatte über dem Inlay angeordneten, sich in Arbeit erhitzendem elektrischen SMD-Bauteils mit zugehörigen Anschlussbeinchen und einem dazwischen angeordneten Erhitzungsbereich hin zu einem auf der anderen Seite der Leiterplatte angeordneten Kühlkörper, **dadurch gekennzeichnet, dass** die Erstreckung des Inlays (5) größer ist als der von zugehörigen Anschlussbeinchen (7) eingeschlossene Erhitzungsbereich (15) des wenigstens einzigen über dem Inlay (5) angeordneten SMD-Bauteils (6), dass die Leiterplatte (1) mit einer Zusatzlage (L1, 11) versehen ist, die oberhalb des Inlays (5) und gleichzeitig unterhalb des wenigstens einzigen über dem Inlay (5) angeordneten SMD-Bauteils (6) angeordnet ist, dass die Zusatzlage (L1, 11) in der Weise ausgebildet ist, dass das wenigstens einzige über dem Inlay (5) angeordnete SMD-Bauteil (6) auf der Zusatzlage (L1, 11) elektrisch isoliert von dem darunter angeordneten Inlay (5) mit seinen Anschlussbeinchen (7) elektrisch anzuschließen ist, und dass die Zusatzlage (L1, 11) in der Weise weiter ausgebildet ist, dass unterhalb der Erhitzungsbereiche (15) der über dem Inlay (5) angeordneten SMD-Bauteile (6) unter Erfassung jeweils möglichst des gesamten Erhitzungsbereichs (15) eines betreffenden SMD-Bauteils (6) innerhalb der Zusatzlage (L1, 11) wärmetechnische Vorkehrungen (14) getroffen sind, durch die die Wärme von den Erhitzungsbereichen (15) der SMD-Bauteile (6) gut bis sehr gut zum darunter angeordneten Inlay (5) befördert ist.

2. Leiterplatte nach Anspruch 1, **dadurch gekennzeichnet, dass** der gegenüber den SMD-Bauteilen (6) auf der anderen Seite der Leiterplatte (1) angeordnete Kühlkörper (13) mit technischen Mitteln (8) an das Inlay (5) gepresst ist.

3. Leiterplatte nach Anspruch 1 oder 2, **dadurch gekennzeichnet, dass** die Leiterplatte (1) mit einer zweiten Zusatzlage (L6, 12) zwischen Inlay (5) und Kühlkörper (13) versehen ist, die ihrerseits Träger wenigstens eines einzigen elektrischen Leitungsbildes ist und zwischen dem Inlay (5) und dem Kühlkörper (13) wärmetechnische Vorkehrungen (16) aufweist, an die der Kühlkörper (13) mit technischen Mitten (8) gepresst und durch die die Wärme vom Inlay (5) gut bis sehr gut zum Kühlkörper (13) befördert sind.

4. Leiterplatte nach einem der Ansprüche 1 bis 3, **dadurch gekennzeichnet, dass** den wärmetechnischen Vorkehrungen (14; 16) das Vorsehen von Durchgangsöffnungen durch die betreffenden Zusatzlagen (L1, 11; L6, 12) zu Grunde liegt, die mit einem wärmetechnisch gut bis sehr gut leitendem Material verfüllt sind.

5. Leiterplatte nach einem der Ansprüche 1 bis 3, **dadurch gekennzeichnet, dass** den wärmetechnischen Vorkehrungen (L1, 11; L6, 12) das Vorsehen einer möglichst großen Anzahl von mit einem wärmetechnisch gut bis sehr gut leitendem Material verfüllten Vias oder Micro-Vias (16) zu Grunde liegt.

6. Leiterplatte nach einem der vorherigen Ansprüche, **dadurch gekennzeichnet, dass** die Leiterplatte (1) als Mehrlagenleiterplatte ausgebildet ist.

7. Leiterplatte nach einem der vorherigen Ansprüche, **dadurch gekennzeichnet, dass** zumindest die erste Zusatzlage (L1, 11) mit einem hochfrequenztechnisch geeigneten Material gebildet ist.

8. Leiterplatte nach einem der Ansprüche 3 bis 7, **dadurch gekennzeichnet, dass** zumindest die zweite Zusatzlage (L2, 12) mit einem Standard-Leiterplattenmaterial gebildet ist.

9. Leiterplatte nach einem der vorherigen Ansprüche, **dadurch gekennzeichnet, dass** die Bauteile (6) SMD-Bauteile sind, die als solche Teil einer Hochfrequenz-Hochleistungsendstufe und/oder Hochfrequenzschaltung sind.

## Claims

1. Printed circuit board with thermally conductive inlay which extends within the plane of the printed circuit board with the thickness of the printed circuit board, has good to very good thermal conductivity and serves for conducting through the printed circuit board heat from at least a single electrical SMD component which is arranged above the inlay on one side of the printed circuit board and heats up in operation, with associated connection pins and a heating region arranged therebetween, through to a heat sink arranged on the other side of the printed circuit board, **characterized in that** the extent of the inlay (5) is larger than the heating region (15) - enclosed by associated connection pins (7) - of the at least single SMD component (6) arranged above the inlay (5), **in that** the printed circuit board (1) is provided with an additional layer (L1, 11) arranged above the inlay (5) and at the same time below the at least single SMD component (6) arranged above the inlay (5), **in that** the additional layer (L1, 11) is embodied in such a way that the at least single SMD component (6) arranged above the inlay (5) can be electrically connected by its connection pins (7) on the additional layer (L1, 11) in a manner electrically insulated from the inlay (5) arranged underneath, and **in that** the additional layer (L1, 11) is further embodied in such a way that, below the heating regions (15) of the SMD components (6) arranged above the inlay (5), whilst covering in each case as far as possible the entire heating region (15) of a relevant SMD component (6), within the additional layer (L1, 11), thermal-technological precautions (14) are taken by means of which the heat is conveyed from the heating regions (15) of the SMD components (6) well to very well to the inlay (5) arranged underneath.

2. Printed circuit board according to Claim 1, **characterized in that** the heat sink (13) arranged opposite the SMD components (6) on the other side of the printed circuit board (1) is pressed onto the inlay (5) by technical means (8).

3. Printed circuit board according to Claim 1 or 2, **characterized in that** the printed circuit board (1) is provided with a second additional layer (L6, 12) between inlay (5) and heat sink (13), which layer, for its part, is the carrier of at least a single electrical lead pattern and has, between the inlay (5) and the heat sink (13), thermal-technological precautions (16) onto which the heat sink (13) is pressed by technical means (8) and by means of which the heat is conveyed from the inlay (5) well to very well to the heat sink (13).

4. Printed circuit board according to any of Claims 1 to 3, **characterized in that** the thermal-technological precautions (14; 16) are based on the provision of through openings through the relevant additional layers (L1, 11; L6, 12) which are filled with a material having good to very good conductivity from a thermal-technological standpoint.

5. Printed circuit board according to any of Claims 1 to 3, **characterized in that** the thermal-technological precautions (L1, 11; L6, 12) are based on the provision of a largest possible number of vias or micro-vias (16) filled with a material having good to very good conductivity from a thermal-technological standpoint.

6. Printed circuit board according to any of the preceding claims, **characterized in that** the printed circuit board (1) is embodied as a multilayer printed circuit board.

7. Printed circuit board according to any of the preceding claims, **characterized in that** at least the first additional layer (L1, 11) is formed with a radio-frequency-technologically suitable material.

8. Printed circuit board according to any of Claims 3 to 7, **characterized in that** at least the second additional layer (L2, 12) is formed with a standard printed circuit board material.

9. Printed circuit board according to any of the preceding claims, **characterized in that** the components (6) are SMD components which as such are part of a radio-frequency high-power output stage and/or radio-frequency circuit.

## Revendications

1. Carte de circuits imprimés comportant un inlay, bon à très bon conducteur thermique, s'étendant à l'intérieur du plan de la carte de circuits imprimés suivant l'épaisseur de la carte de circuits imprimés et destiné à conduire à travers la carte de circuits imprimés la chaleur d'au moins un composant électrique CMS, lequel est agencé sur l'un des côtés de la carte de circuits imprimés au-dessus de l'inlay, chauffe en travaillant et comporte des broches de raccordement associées ainsi qu'une zone d'échauffement entre celles-ci, en direction d'un corps de refroidissement agencé sur l'autre côté de la carte de circuits imprimés, **caractérisée en ce que** l'extension de l'inlay (5) est supérieure à la zone d'échauffement (15), incluse par des broches de raccordement associées (7), du au moins un composant CMS (6) agencé au-dessus de l'inlay (5), **en ce que** la carte de circuits imprimés (1) est munie d'une couche supplémentaire (L1, 11) qui est agencée au-dessus de l'inlay (5) et simultanément au-dessous du au moins un composant CMS (6) agencé au-dessus de l'inlay (5), **en ce que** la couche supplémentaire (L1, 11) est conçue de telle sorte que l'au moins un composant CMS (6) agencé au-dessus de l'inlay (5) est à raccorder électriquement par ses broches de raccordement (7) sur la couche supplémentaire (L1, 11) d'une manière isolée électriquement de l'inlay (5) agencé au-dessous et **en ce que** la couche supplémentaire (L1, 11) est aussi conçue de telle sorte que, au-dessous des zones d'échauffement (15) des composants CMS (6) agencés au-dessus de l'inlay (5), des dispositions thermiques techniques (14) sont prisses à l'intérieur de la couche supplémentaire (L1, 11) en comprenant à chaque fois le plus possible de la totalité de la zone d'échauffement (15) d'un composant CMS (6) considéré, dispositions thermiques techniques grâce auxquelles la chaleur des zones d'échauffement (15) des composants CMS (6) est bien à très bien transportée jusqu'à l'inlay (5) agencé au-dessous.

2. Carte de circuits imprimés selon la revendication 1, **caractérisée en ce que** le corps de refroidissement (13) agencé par rapport aux composants CMS (6) sur l'autre côté de la carte de circuits imprimés (1) est pressé avec des moyens techniques (8) sur l'inlay (5).

3. Carte de circuits imprimés selon la revendication 1 ou 2, **caractérisée en ce que** la carte de circuits imprimés (1) est munie d'une deuxième couche supplémentaire (L6, 12) entre l'inlay (5) et le corps de refroidissement (13), laquelle deuxième couche supplémentaire est porteuse d'au moins un dessin de circuit électrique et comporte entre l'inlay (5) et le corps de refroidissement (13) des dispositions thermiques techniques (16) sur lesquelles le corps de refroidissement (13) est pressé avec des moyens techniques (8) et grâce auxquelles la chaleur de l'inlay (5) est bien à très bien transportée jusqu'au corps de refroidissement (13).

4. Carte de circuits imprimés selon l'une des revendications 1 à 3, **caractérisée en ce que** les dispositions thermiques techniques (14 ; 16) sont basées sur des ouvertures traversantes qui sont prévues à travers les couches supplémentaires concernées (L1, 11 ; L6, 12) et qui sont remplies d'un matériau bon à très bon conducteur de chaleur.

5. Carte de circuits imprimés selon l'une des revendications 1 à 3, **caractérisée en ce que** les dispositions thermiques techniques (L1, 11 ; L6, 12) sont basées sur le plus grand nombre possible de trous ou micro-trous d'interconnexion (16) remplis d'un matériau bon à très bon conducteur de chaleur.

6. Carte de circuits imprimés selon l'une des revendications précédentes, **caractérisée en ce que** la carte de circuits imprimés (1) est conçue comme une carte de circuits imprimés à couches multiples.

7. Carte de circuits imprimés selon l'une des revendications précédentes, **caractérisée en ce qu'**au moins la première couche supplémentaire (L1, 11) est formée avec un matériau convenant bien à la technique des hautes fréquences.

8. Carte de circuits imprimés selon l'une des revendications 3 à 7, **caractérisée en ce qu'**au moins la deuxième couche supplémentaire (L2, 12) est formée avec un matériau de carte de circuits imprimés standard.

9. Carte de circuits imprimés selon l'une des revendications précédentes, **caractérisée en ce que** les composants (6) sont des composants CMS qui font partie en tant que tels d'un étage de sortie à grand rendement à haute fréquence et/ou d'un circuit à haute fréquence.
